# EUROPÄISCHE PATENTSCHRIFT

(11) **EP 1 183 709 B1**
(45) Veröffentlichungstag und Bekanntmachung des Hinweises auf die Patenterteilung: **11.04.2007**
(21) Anmeldenummer: 00938704.4
(22) Anmeldetag: 30.05.2000
(51) Int. Cl.: H01J 37/32

(54) **LINEAR AUSGEDEHNTE ANORDNUNG ZUR GROSSFLÄCHIGEN MIKROWELLENBEHANDLUNG UND ZUR GROSSFLÄCHIGEN PLASMAERZEUGUNG**
LINEARLY EXTENDED DEVICE FOR LARGE-SURFACE MICROWAVE TREATMENT AND FOR LARGE SURFACE PLASMA PRODUCTION
DISPOSITIF A DILATATION LINEAIRE DESTINE AU TRAITEMENT MICRO-ONDES DE GRANDE SURFACE ET A LA PRODUCTION DE PLASMA GRANDE SURFACE

(30) Priorität: 04.06.1999 DE 19925493
(43) Veröffentlichungstag der Anmeldung: 06.03.2002
(73) Patentinhaber: Fraunhofer-Gesellschaft zur Förderung der angewandten Forschung e.V., 80686 München (DE)
(72) Erfinder: EMMERICH, Rudolf, D-76446 Durmersheim (DE); KAISER, Mathias, D-76307 Karlsbad (DE); URBAN, Helfried, D-75015 Bretten (DE); ELSNER, Peter, D-76327 Pfinztal (DE); BAUMGÄRTNER, Klaus-Martin, D-64407 Grumbach (DE); RÄUCHLE, Eberhard, D-71686 Remseck (DE); RÄUCHLE, Konstantin, D-76186 Remseck (DE)
(86) Internationale Anmeldenummer: PCT/EP2000/004899
(87) Internationale Veröffentlichungsnummer: WO 2000/075955

(56) Entgegenhaltungen:
- DE-A- 3 923 390
- DE-A- 19 812 558
- DE-C- 19 503 205
- DE-C- 19 507 077

## Beschreibung

Die Erfindung betrifft eine Vorrichtung zur Erzeugung von Mikrowellen zur Behandlung von Werkstücken nach dem Oberbegriff des Anspruchs 1.

Die WO 96/23318 (entsprechend DE 195 07 077 C1) zeigt einen gattungsgemäßen Plasmareaktor mit einem rotationssymmetrischen Hohlraumresonator in Form eines Ellipsoidresonators. In einen ersten Fokuspunkt ragt das freie Ende eines Koppelstiftes, während ein zweiter Fokuspunkt des Ellipsoidresonators von einer Quarzglocke umschlossen ist und derart einen Plasmabehandlungsraum um den Fokuspunkt bildet. Nachteilig ist, daß der Behandlungsbereich ein reduzierter, lediglich radial um den Fokuspunkt konzentrierter ist.

Aus der DE 195 03 205 Cl ist eine Vorrichtung zur Erzeugung von Plasma in einen Unterdruckbehälter mit Hilfe von elektromagnetischen Wechselfeldern bekannt, bei der ein stabförmiger Leiter innerhalb eines Rohres aus isolierendem Werkstoff durch den Unterdruckbehälter geführt ist, wobei der Innendurchmesser des Rohres größer als der Durchmesser des Leiters ist. Das Rohr ist derart gasgefüllt, daß eine Plasmabildung in ihm vermieden wird. Eine solche setzt unmittelbar um das Rohr ein, da hier die Strahlungsintensität am stärksten ist. Nachteilig ist der hohe Energieeintrag auf das Rohr, die Veränderung der Abstrahlungen durch Verunreinigungen und die Gefahr einer Beschichtung des Rohres selbst.

Die DE 39 23 390 A1 zeigt eine Vorrichtung zur Bildung eines großflächigen aufgedampften Films unter Verwendung von wenigstens zwei getrennt gebildeten aktivierten Gasen. Hierzu sind parallel zu zwei gegenüberliegenden Seiten eines im wesentlichen rechteckigen Gehäuses zwei Mikrowellen-Hohlleiter mit jeweils eigenem zugeordneten Mikrowellengenerator angeordnet, von denen sich senkrecht zum Verlauf der Hohlleiter jeweils wechselweise ebenfalls parallel zueinander verlaufende Stabantennen in das Gehäuse hineinerstrecken und auf der dem jeweiligen Hohlleiter abgewandten Seite innerhalb des Gehäuses enden und abgeschlossen sind. Innerhalb einer solchen Antenne bilden sich stehende Mikrowellen mit unterschiedlicher Intensität über die Antenne hin. Eine gewisse Homogenisierung in Antennenrichtung wird eben durch die Parallelanordnung mehrerer jeweils wechselnd von einer anderen Seite eingespeiste Antennen erreicht. Diese Ausgestaltung ist konstruktiv aufwendig und damit teuer.

Der Erfindung liegt die Aufgabe zugrunde, die gattungsgemäße Vorrichtung zur Erzeugung von Mikrowellen zur, insbesondere auch kontinuierlichen Behandlung von größeren Werkstücken weiterzuentwickeln.

Erfindungsgemäß wird die genannte Aufgabe bei einer Vorrichtung der gattungsgemäßen Art dadurch gelöst, daß der Hohlraumresonator länglich ausgebildet ist und dem Verlauf der eine über ihre Länge hin homogenen Behandlungszone erzeugenden Mikrowellen-Antenne folgt, daß der gestreckte Auskopplungsbereich der Mikrowellen dem Leiter folgt und daß der Auskopplungsbereich der Mikrowellen sich im wesentlichen entlang des gestreckten Fokusbereichs des Hohlraumresonators erstreckt.

Der Erfindung liegt die Aufgabe zugrunde, einen größeren, möglichst homogenen Mikrowellenbehandlungsbereich zur Behandlung von Werkstücken zu schaffen, der auch eine kontinuierliche Behandlung erlaubt.

Erfindungsgemäß wird die genannte Aufgabe mit einer Vorrichtung der eingangs genannten Art gelöst, welche die kennzeichnenden Merkmale des Anspruchs 1 aufweist.

Durch die Erfindung wird durch eine für Bündelung von Mikrowellen zumindest in Form einer Parallelisierung derselben eine linear ausgedehnte, in Richtung ihrer Längserstreckung homogene Behandlungszone ermöglicht, wobei die Breite der Behandlungszone senkrecht zur Längserstreckung durch geeignete Gehäuseformung variierbar ist.

Die Mikrowellenauskopplung kann auf verschiedene Weise erfolgen. Gemäß einer ersten bevorzugten Ausgestaltung ist vorgesehen, daß die Mikrowellen-Antenne eine von einem Dielektrikum umgebenen elektrisch leitenden gestreckten Leiter gebildet ist, der sich im Fokusbereich des Hohlraumresonators befindet, wobei entweder das Dielektrikum ein den Leiter eng umgebender Festkörper ist oder daß das Dielektrikum durch Gas gebildet ist, das mit einem den Leiter umgebenden dielektrischen Rohr radial begrenzt werden kann.

Eine alternative Ausgestaltung sieht vor, daß die Mikrowellen-Antenne durch einen Koaxialleiter mit Innen- und Außenleiter gebildet ist, wobei wiederum entweder der Außenleiter ein einen Innenleiter lediglich teilweise umgebender Teilzylinder ist, der auf der dem Scheitelbereich des Hohlraumresonators abgewandten Bereich des Innenleiters angeordnet ist oder aber, daß der Außenleiter eine Mantelbeschichtung auf einem dem Innenleiter umgebenden Dielektrikum ist. Alternativ kann vorgesehen sein, daß der Außenleiter zumindest eine dem Scheitelbereich des Hohlraumresonators zugewandte Öffnung aufweist, die im Fokusbereich des Hohlraumresonators liegt und in Form von Schlitzen oder Löchern beschaffen ist.

Eine weitere Ausgestaltung sieht vor, daß die Mikrowellen-Antenne durch einen Hohlleiter mit im Fokusbereich des Hohlraumresonators liegenden Austrittsöffnungen als Auskopplungsbereich ausgebildet ist.

Die Mikrowellen können dabei jeweils von einem Ende oder von beiden Enden her in die Mikrowellen-Antenne(n) Leiter eingespeist werden.

Während insbesondere lediglich zur Wärmebehandlung von Werkstücken der sich an den ersten Scheitelbereich anschließende nicht divergierende Bereich durch parallele Wandung ausgebildet wird, sieht eine bevorzugte Ausgestaltung vor, daß der nicht divergierende Bereich ein sich vom ersten Scheitelbereich fortverjüngende zweiter Scheitelbereich ist und daß das Werkstück im wesentlichen in Fokusbereichen des zweiten Scheitelbereiches anordbar ist. Der sich verjüngende Bereich kann im Querschnitt die Form einer Parabel oder eines Teils einer Ellipse haben. Neben einer Mikrowellen-Wärmebehandlung ist diese Ausgestaltung insbesondere zur Plasmabehandlung von Werkgut geeignet, wobei zur Kontrolle der verwendeten Gase, insbesondere hinsichtlich Druck, Gasart und Gasfluß, der Plasmabehandlungsbereich vom Mikrowellenerzeugungsbereich abzutrennen ist.

Dies kann dadurch geschehen, daß der Trennkörper im wesentlichen eine ebene Wandung ist, daß der Trennkörper ein halbzylindrischer Mantel ist, der über dem Behandlungsfokus angeordnet und fest und dicht mit der Wandung des Gehäuses verbunden ist, oder aber dadurch, daß der Trennkörper durch ein den Behandlungsfokus umgebendes dielektrisches Rohr gebildet ist.

Insbesondere wenn bei der Behandlung von Werkstücken verhindert werden soll, daß austretende Dämpfe oder abgespritzte Flüssigkeitstropfen auf die Mikrowellen-Antenne treffen, sieht eine weitere bevorzugte Ausgestaltung vor, daß erster Scheitelbereich und nicht divergierender Bereich unter einem endlichen Winkel zueinander angeordnet sind und daß zwischen beiden Bereichen eine Reflektionsfläche vorgesehen ist.

Zur Erhöhung der Mikrowellenintensität im Behandlungsbereich kann vorgesehen sein, daß mindestens zwei erste Scheitelbereiche die jeweils eine Mikrowellen-Antenne aufweisen, sich parallel zueinander erstreckend angeordnet sind und in einen gemeinsamen nicht divergierenden Bereich übergehen. Hierbei sind alternative Ausgestaltungen wählbar, wobei gemäß einer ersten Ausgestaltung vorgesehen sein kann, daß die mindestens zwei ersten Scheitelbereiche benachbart zueinander angeordnet sind.

Eine weitere Ausgestaltung sieht vor, daß zwei Mikrowellen-Antennen relativ zu einem zweiten Behandlungsfokus diagonal gegenüber angeordnet sind. Zur weiteren Erhöhung des Energieeintrags, insbesondere bei der Plasmabehandlung kann darüber hinaus vorgesehen sein, daß um einen Behandlungsfokus herum mehrere Mikrowellen-Antennen in ihnen zugehörigen Hohlraumresonatoren symmetrisch verteilt angeordnet sind.

Zur Verbreitung des Behandlungsbereichs sieht eine weitere Ausgestaltung vor, daß mehrere Mikrowellen-Antennen zumindestens auf einer Seite eines Werkstücks parallel nebeneinander in ihnen zugehörigen Hohraumresonatoren angeordnet sind.

Die erfindungsgemäße Vorrichtung kann in verschiedener Weise eingesetzt werden.

Mit gemäß einer ersten Anwendungsausgestaltung kann vorgesehen sein, daß zur Behandlung innerhalb des Gehäuses Ab- und Aufwickeldorne vorgesehen und mindestens eine Umlenk- oder Führungsweise in der Nähe des Arbeitsfokus angeordnet sind. Zur Mikrowellen-Behandlung von Schüttgut sieht die Erfindung vor, daß im Behandlungsbereich ein Mischer angeordnet ist. Während die Behandlung dabei diskontinuierlich erfolgt und nach der Behandlung das Schüttgut im Plasmabehandlungsraum ausgetauscht werden muß, sieht eine quasi kontinuierliche Behandlung eine Förderschnecke im Bereich des Arbeitsfokus zur Förderung des zu behandelnden Materials vor. Zur Reinigung von Abgas kann weiterhin vorgesehen sein, daß eine sich entlang des Behandlungsfokus erstreckendes, mit einer Pumpe versehenes Gasführungsrohr angeordnet ist.

Weitere Vorteile und Merkmale der Erfindung ergeben sich aus den Ansprüchen und aus der nachfolgenden Beschreibung, in der Ausführungsbeispiele der Erfindung unter Bezugnahme auf die Zeichnungen im einzelnen erläutert sind. Dabei zeigt bzw. zeigen:
- Fig. 1a: eine erfindungsgemäße Ausgestaltung einer Vorrichtung zur Erzeugung von Mikrowellen und Plasmabehandlung mit einem in einem Dielektrikum angeordneten linearen Leiter im Längsschnitt;
- Fig. 1b: die Ausgestaltung der Fig. 1a im Querschnitt;
- Fig. 1c: die zusätzliche Ausgestaltung der Fig. 1a, 1b in perspektivischer Darstellung;
- Fig. 2: eine erfindungsgemäße Vorrichtung zur Erzeugung von Mikrowellen mit zwei Mikrowellen-Antennen;
- Fig. 3: eine andere Ausgestaltung der erfindungsgemäßen Vorrichtung mit einem linearen Leiter, der durch einen teilweise geöffneten leitfähigen Mantel abgeschirmt ist;
- Fig. 4: eine Ausführungsform mit einem Koaxialleiter, dessen Außenleiter geschlitzt ist;
- Fig. 5: eine Ausführungsform entsprechend Fig. 4, wobei der Außenleiter gelocht ist.
- Fig. 6: eine weitere Ausgestaltung der erfindungsgemäßen Vorrichtung mit einem geschlitzten Hohlleiter;
- Fig. 7 bis 9: weitere schematische Darstellungen der erfindungsgemäßen Vorrichtung mit verschiedenen Ausführungsformen zur Mikrowellenbestrahlung von Bahnen;
- Fig. 12: eine Ausführungsform zur Mikrowellenbestrahlung einer Bahn mit zwei parallel ausgerichteten Mikrowellenquellen;
- Fig. 13: eine weitere Ausgestaltung einer erfindungsgemäßen Vorrichtung zur Mikrowellenbestrahlung einer Bahn mit mehreren parallel nebeneinander angeordneten Mikrowellen-Antennen;

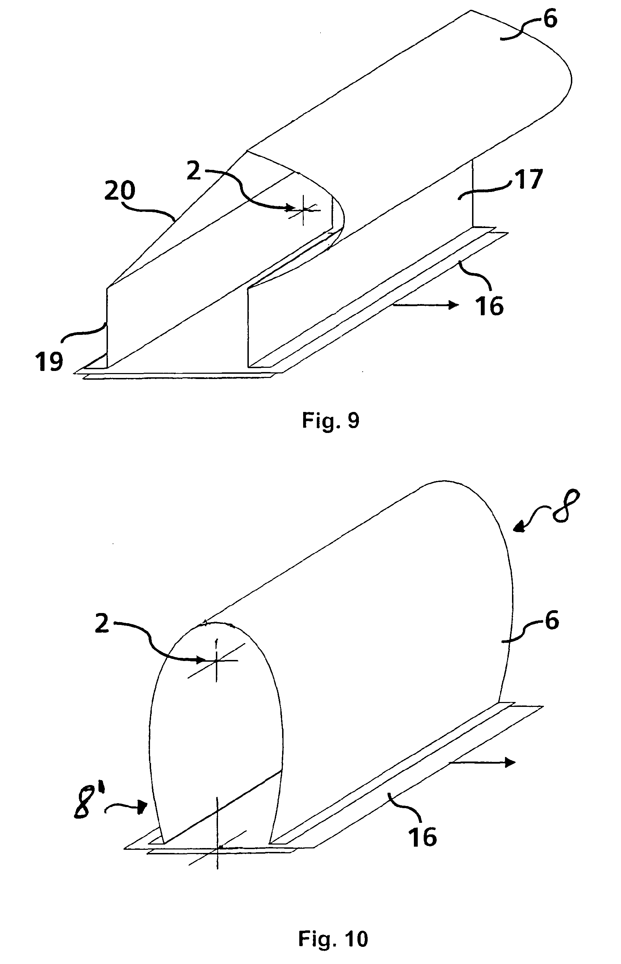

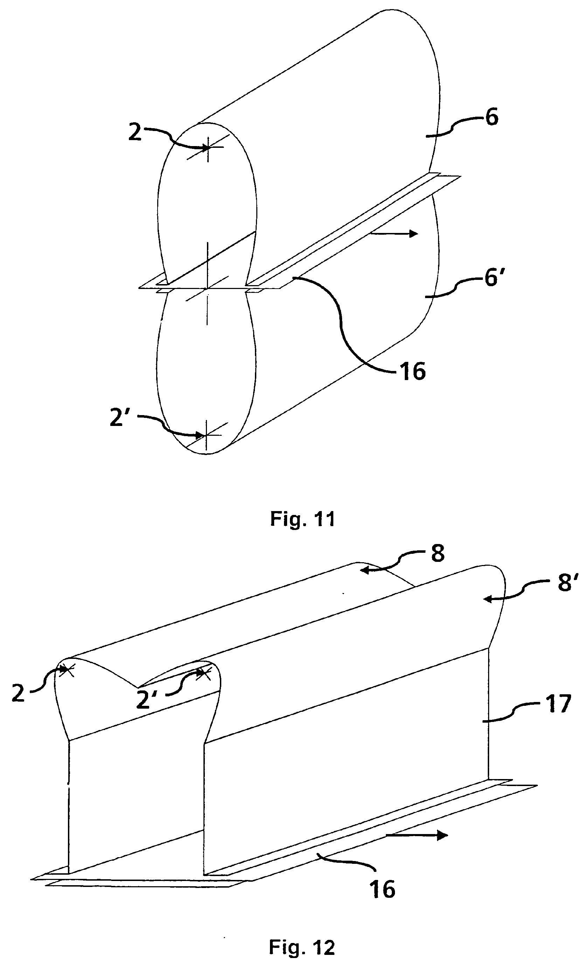

- Fig. 10 und 11: Ausgestaltungen zur Mikrowellenbestrahlung einer Bahn mit erhöhtem Wärmeeintrag in die Bahn;

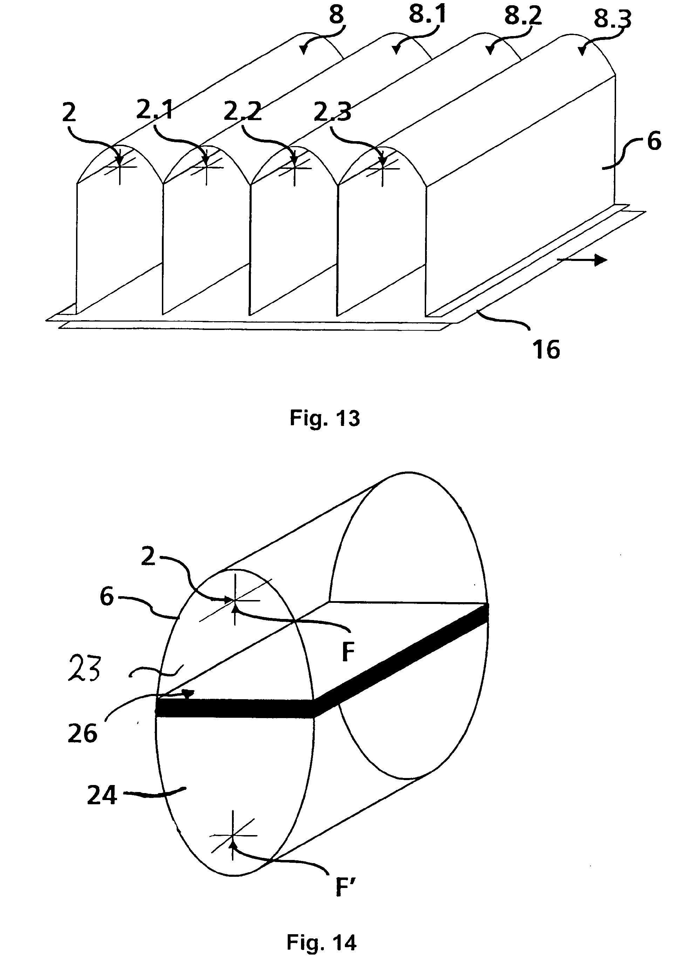

- Fig. 14 bis 17: verschiedene Ausführungsformen der erfindungsgemäßen Vorrichtung zur Erzeugung eines Plasmas insbesondere zur Beschichtung von Gegenständen;

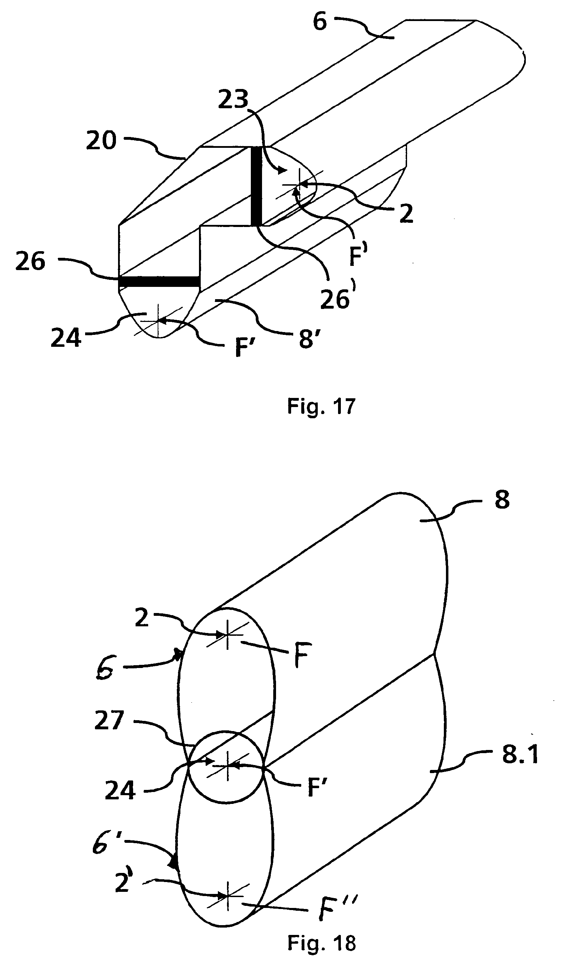

- Fig. 18 bis 20: Ausgestaltung zur Erzeugung eines Plasmas durch sich zwei und mehr parallel zueinander erstreckende Mikrowellen-Antennen;

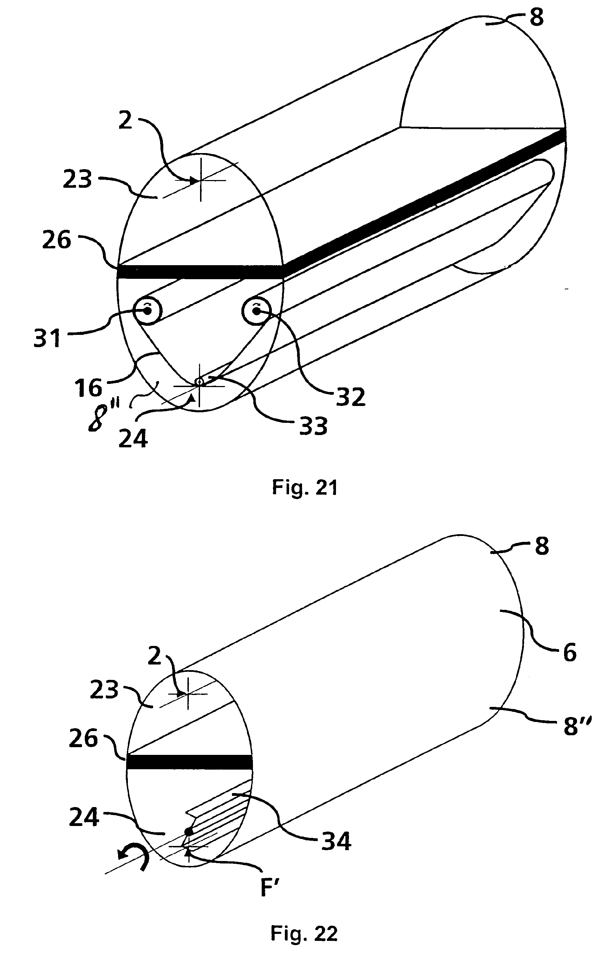

- Fig. 21: eine Ausgestaltung zur kontinuierlichen Plasmabehandlung einer Bahn;

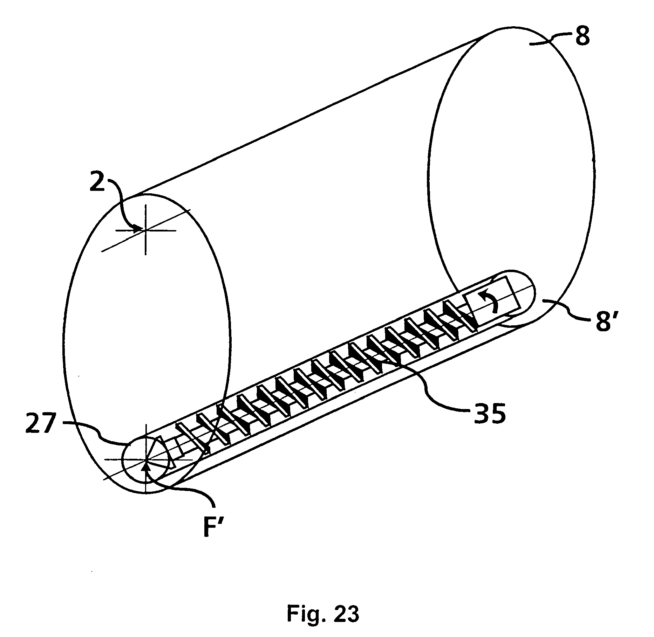

- Fig. 22: eine Ausführungsform zur Plasmabehandlung von Schüttgut mit einem Mischer;
- Fig. 23: eine Vorrichtung zur kontinuierlichen Mikrowellenbehandlung des Mediums in einer Förderschnecke; und
eine Vorrichtung zur Abgasreinigung mittels Mikrowellen.

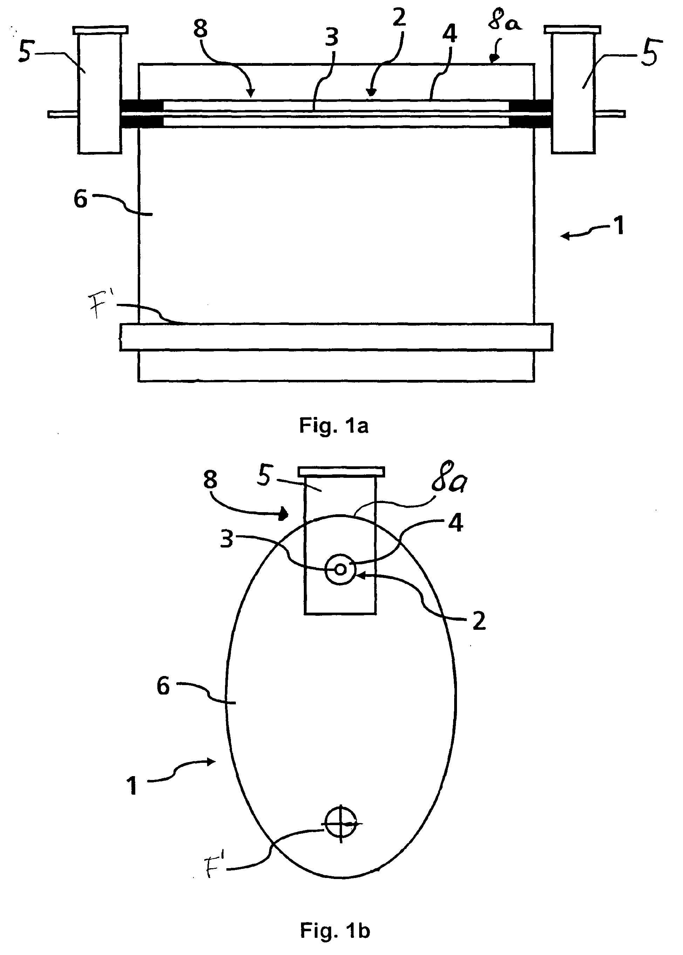

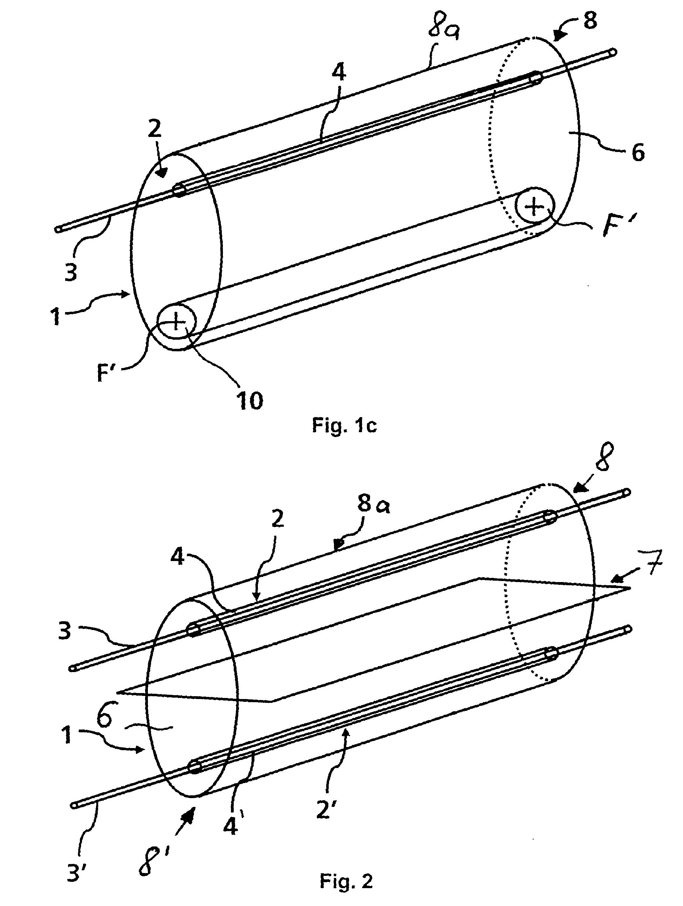

In der Ausgestaltung der Fig. 1a und 1b weist die erfindungsgemäße Vorrichtung 1 zur Erzeugung von Mikrowellen - hier mit Ellipsen-Querschnitt - eine Mikrowellen-Antenne 2 mit einem gestreckten linearen Leiter 3 in Form eines Stabes, Drahtes oder Kupferrohres auf, der von einem Dielektrikum 4, beispielsweise in Form eines mit Abstand angeordneten und Luft enthaltenden Quarzrohres oder einen Keramikstab umgeben ist.

Die Ankopplung der Mikrowellen erfolgt über eine oder beide Stirnseiten des Leiters 3, in üblicher Weise mit Mikrowellen-Adaptern 5 und ist daher nicht näher dargestellt.

Die beschriebene Mikrowellen-Antenne 2 befindet sich in einem ihr folgenden gestreckten Hohlraumresonator 6 mit einer von seinem Scheitel 8a zumindest teilweise parabel- oder ellipsenförmigen Kontur - hier mit Ellipsen-Querschnitt - die einen parallel zur Antenne 2 bzw. dem Leiter 3 verlaufenden ersten Scheitelbereich 8 aufweist, der einen ersten Fokusbereich hat - der durch die Fokuslinie parallel symmetrisch einfallender Strahlen bestimmt ist. In der Ausgestaltung der Fig. 1 findet sich der lineare Leiter 3 genau im Fokusbereich des Hohlraumresonators 6 bzw. dessen (ersten) Scheitelbereichs 8. Bei der Ausgestaltung der Fig. 1a und 1b weist der Hohlraumresonator 6 einen zweiten Scheitelbereich 8' mit einem mit einem Kreuz (X) gekennzeichneten zweiten gestreckten Fokusbereich F', den Behandlungsfokus auf, der von einem Rohr 10 umgeben ist, in dem so ein Plasma erzeugt und eine Plasmabehandlung eines Werkstücks, wie eine Bedichtung an einer Plasmaphase eines Gases durchgeführt werden kann.

Die erfindungsgemäße Vorrichtung kann, wie in Fig. 2 angedeutet, auch zur Erwärmung eines Werkstücks, wie einer Bahn dienen, beispielsweise zum Trocknen einer solchen oder zum Aushärten einer auf ihr aufgebrachten Beschichtung. Eine Ausgestaltung einer solchen Anwendung ist in der Fig. 2 dargestellt. Ein zwei erste Scheitelbereiche 8,8' aufweisender Hohlraumresonator 6 ist bei dieser Ausgestaltung im Schnitt ellipsenförmig ausgebildet. Zwei Mikrowellen-Antennen 2,2' finden sich mit ihrem drahtförmigen (Innen) Leiter 3,3' in den Fokusbereichen des Hohlraumresonators 6. Mit Abstand zu den Mikrowellen-Antennen 2,2' ist ein flächiges Werkstück 7 angeordnet, das so durch die Mikrowellen-Antennenstrahlung beidseitig erwärmt wird. Grundsätzlich ist auch eine einseitige Erwärmung in einem im Schnitt parabel- oder halbellipsenförmigen Hohlraumresonator 6 möglich. Im folgenden werden weitere Ausgestaltungen der Erfindung beschrieben.

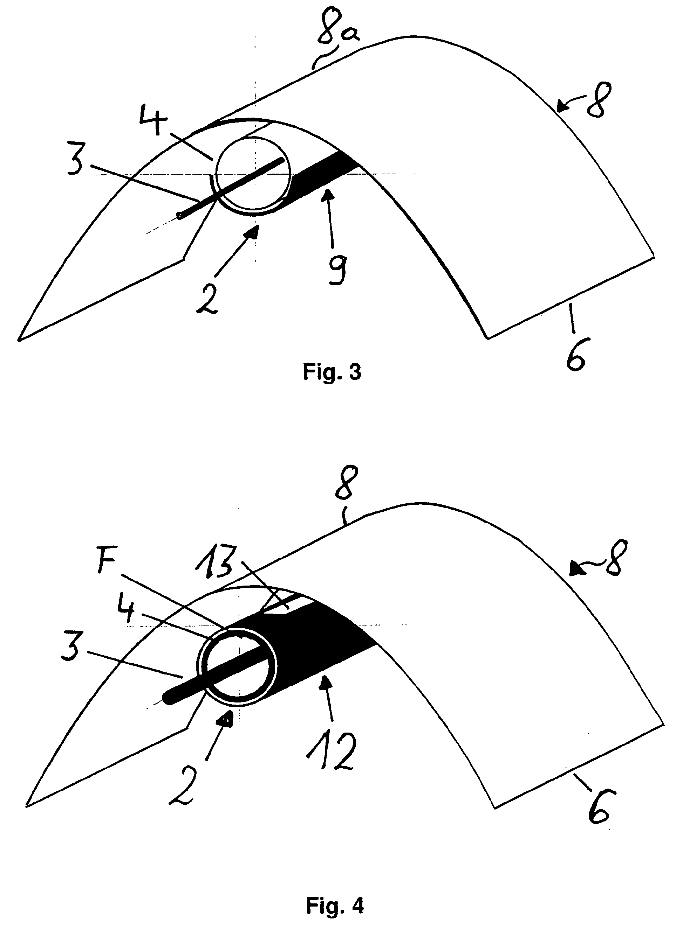

Die Ausgestaltung der Fig. 3 zur Mikrowellenauskopplung weist innerhalb des Hohlraumresonators 6 einen teilweise geöffneten koaxialen Leiter auf. Dieser ist durch einen in einem Dielektrikum 4 angeordneten Innenleiter 3 gebildet, bei dem das Dielektrikum koaxial zum Leiter auf dessen dem den Scheitel 8a des Hohlraumresonators 6 abgewandten Bereich mit einem teilweise geöffneten leitfähigen Mantel 9 versehen ist. Die Mikrowellenstrahlung wird hierdurch gegen den Scheitel 8a (Stirnseitenbereich) des Hohlraumresonators gerichtet und von diesem in den übrigen Bereich des Hohlraumresonators und zu bearbeitenden Werkstücken hin (hierzu weiter unten) reflektiert.

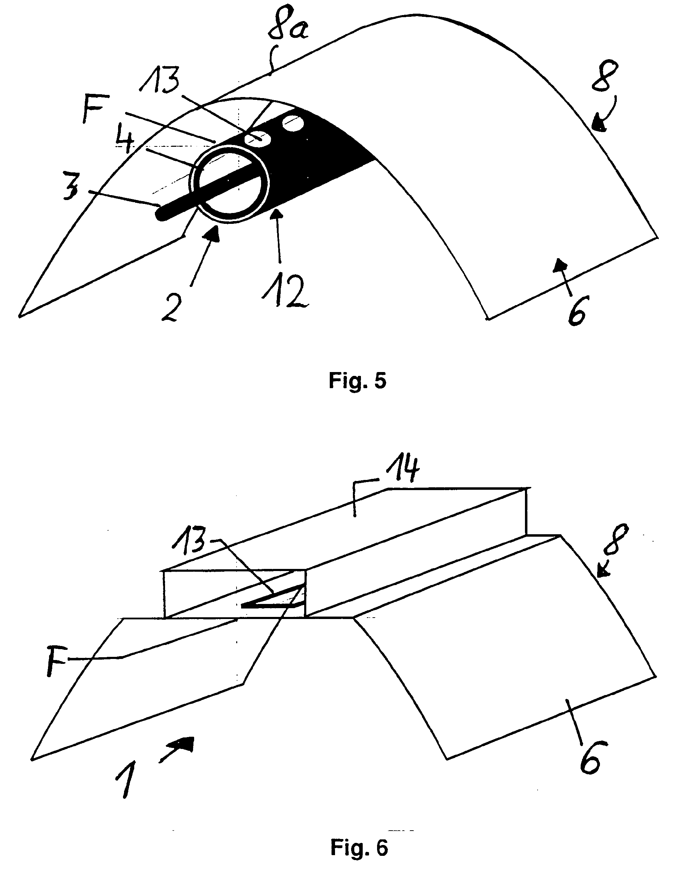

Die Fig. 4 und 5 zeigen als Mikrowellen-Antenne 2 ebenfalls einen Koaxialleiter. Dieser weist in der dargestellten Ausführungsform wiederum einen Leiter 3 auf, der aber nun mit Abstand von einem leitfähigen Rohr als Außenleiter 12 umgeben ist, welches auf seiner dem Scheitel 8a des Hohlraumresonators 6 zugewandten Seite mit Austrittsschlitzen oder Kreisdurchbrüchen 13 versehen ist. Die Führung der Mikrowellenstrahlung erfolgt daher aus der Ausgestaltung der Fig. 3 entsprechend der der Fig. 2. Das Verhältnis von Schlitzlänge zu Schlitzbreite ist vorteilhafter Weise über die gesamte Länge des Koaxialleiters 11 konstant; dies muß aber nicht der Fall sein.

Während bei den Ausgestaltungen der Fig. 1 und 3 der Leiter bzw. Innenleiter 3 sich im Fokusbereich des Hohlraumresonators 6 befindet, ist dies bei den Ausgestaltungen der Fig. 4 und 5 nicht der Fall. Bei diesen Ausgestaltungen ist die Ebene der Austrittsschlitze 13 im Fokusbereich F des Hohlraumresonators 6 angeordnet.

Die Ausgestaltung der Fig. 6 einer erfindungsgemäßen Vorrichtung zeigt als Mikrowellenleiter einen Hohlleiter 14, der im oberen Bereich des Hohlraumresonators 6 derart angeordnet ist, daß die zum inneren des Hohlraumresonators 6 gerichteten Austrittsschlitze 13 des Hohlleiters 14 ebenfalls wieder im durch ein Kreuz angedeuteten Fokusbereich F des Hohlraumresonators liegen; hier ist der körperlich nicht vorhandene Scheitel des Hohlraumresonators angedeutet.

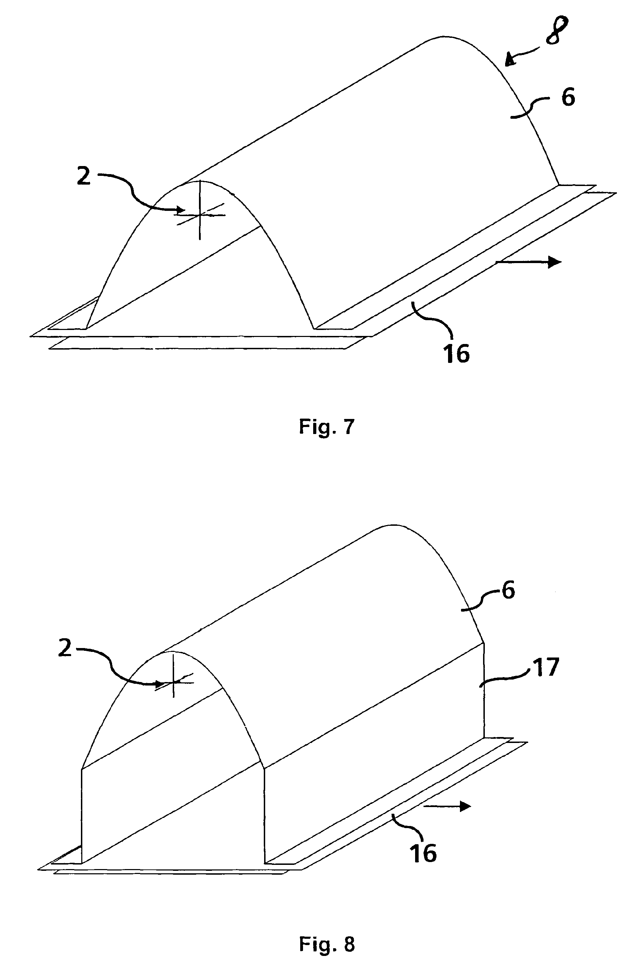

Fig. 7 zeit einen Hohlraumresonator 6 mit lediglich einem ersten Scheitelbereich 8 zur Mikrowellenbehandlung eines Werkstücks 16 in Form einer unter dem Scheitelbereich hindurch gezogenen Materialbahn.

Es kann aus gewissen Gründen notwendig sein, den Abstand zwischen der Mikrowellen-Antenne 2 und dem zu behandelnden Werkstück 16 größer zu wählen. Aus diesem Grunde schließt sich bei der Ausgestaltung der Fig. 8 der erfindungsgemäßen Vorrichtung an den parabel- oder teilellipsenförmig ausgebildeten Scheitelbereich 8 des Hohlraumresonators ein Distanzstück 17 mit parallel zueinander verlaufenden Wandungen an; erst an dieses schließt sich dann der Arbeitsbereich mit einem unter der Mikrowellen-Antenne 2 durchlaufenden Werkstück 16 an. Auch diese Ausgestaltung mit Distanzstück 17 kann symmetrisch mit zwei Mikrowellen-Antennen entsprechend der Fig. 2 ausgebildet sein.

Dabei kann sich die Bahn, allgemein ein Werkstück, auch im Behandlungs-Fokusbereich F' eines Hohlraumresonators 6 bzw. des zweiten Scheitelbereichs befinden, der andere Parameter aufweist als der erste Scheitelbereich 8 des Mikrowellenerzeugungsfokus in dem sich die Mikrowellen-Antenne 2 befindet, also beispielsweise im Querschnitt die Form einer flacheren Parabel aufweisen.

Aus gewissen Gründen kann es sinnvoll oder notwendig sein, die Mikrowellenstrahlen nicht direkt auf das Werkstück zu richten, beispielsweise, wenn aus diesen bei der Behandlung Dämpfe austreten oder Flüssigkeitsspritzer, die die Mikrowellen-Antenne verschmutzen und damit beschädigen können. Letzteres wird bei der Ausgestaltung der Fig. 9 verhindert. Bei dieser Ausgestaltung schließt sich dann an den ersten Scheitelbereich 8 winklig zu diesem vorzugsweise in einem rechten Winkel ein Gehäuseabschnitt 19 mit dem dargestellten Ausführungsbeispiel parallel zueinander verlaufenden Wandungen an, unter dessen Ende das Werkstück 16 hindurchgezogen wird. Zwischen erstem Scheitelbereich 8 und Gehäuseteil 19 ist eine winklig angeordnete Reflektorfläche 20 vorgesehen, die derart angeordnet ist, daß sie die in der Mikrowellen-Antenne 2 erzeugten Mikrowellen auf das Werkstück 16 richtet.

Zur Erhöhung der Intensität der Mikrowellenbehandlung in einem quer zur Verlaufsrichtung des Werkstücks 16 parallel zur Mikrowellen-Antenne 2 ausgerichteten Behandlungsbereich kann vorgesehen sein, einen Hohlraumresonator 6 mit zwei Fokusbereichen vorzusehen in denen sich in der unter Bezugnahme auf die Fig. 1 bis Fig. 4 beschriebenen Weise der Mikrowellenleiter bzw. der Austrittsbereich der Mikrowellen findet, während durch deren anderen Fokusbereich F' (Behandlungsfokus Fig. 10) das Werkstück gezogen wird. Bei dieser Ausgestaltung werden die von der Mikrowellen-Antenne 2 erzeugten Mikrowellen in den zweiten Fokusbereich F' und damit auf das Werkstück fokussiert. Zur beidseitigen Behandlung kann auf der der Mikrowellen-Antenne 2 und dem ersten Scheitelbereich 8 abgewandten Seite des Werkstücks 16 ein entsprechender Hohlraumresonator 6' mit einer zweiten Mikrowellen-Antenne 2' vorgesehen sein, wie dies in Fig. 11 dargestellt ist.

Zur Erhöhung der einseitigen Intensität der Mikrowellenbehandlung eines Werkstücks 16 können auch einseitig desselben zwei Mikrowellen-Antennen 2,2' in ihnen jeweils zugeordneten ersten Scheitelbereichen 8,8' angeordnet sein, wobei die Scheitelbereiche 8,8' des Hohlraumresonators derart angeordnet und ausgerichtet sind, insbesondere ihre Symmetrieflächen, die winklig zueinander verlaufen, daß die Behandlungsbereiche 22 beider Mikrowellen-Antennen 2,2' im wesentlichen übereinstimmen (Fig. 12).

Weiterhin kann es notwendig sein ein Werkstück 16, wie eine Bahn, über einen längeren Zeitraum bzw. eine längere Strecke mit Mikrowellen zu behandeln, als dies mit einer Mikrowellen-Antenne oder zwei auf einen gemeinsamen Bereich gerichteten Mikrowellen-Antennen möglich ist. In diesem Falle können mehrere Mikrowellen-Antennen 2,2.1,2.2,2.3... parallel nebeneinander zueinander ausgerichtet sein und in ersten Scheitelbereichen 8,8.1,8.2,8.3... des Hohlraumresonators angeordnet sein, deren Symmetriemittelflächen parallel zueinander angeordnet sind, wie dies in Fig. 13 dargestellt ist.

Neben einer Wärmebehandlung eines Werkstücks oder von Werkstücken in der oben beschriebenen Form, wobei das Werkstück nicht eine Bahn sein muss, sondern auch auf einem Förderband durch den Behandlungsbereich gefördertes Schüttgut oder dergleichen sein kann, kann die erfindungsgemäße Vorrichtung auch zur Plasmabeschichtung eines Werkstücks oder von Werkstücken mittels Mikrowellen eingesetzt werden.

Hierbei ist die Plasma-Behandlungszone in der sich das Werkstück oder die Werkstücke befinden von dem Mikrowellenerzeugungsbereich in dem sich die Mikrowellen-Antenne 2 befindet, körperlich zu trennen, da die Bedingungen der Gase im Mikrowellenerzeugungsbereich und in der Plasma-Behandlungszone unterschiedlich sein müssen, damit einerseits im Mikrowellenerzeugungsbereich kein Plasma entsteht, andererseits ein solches in der Plasma-Behandlungszone erzeugt wird.

Weiterhin ist es vorteilhaft, zur Erzeugung eines Plasmas die Mikrowellenkonzentration in der Plasma-Behandlungszone zu verstärken, daher hier neben dem ersten Fokusbereich, in dem sich die Mikrowellen-Antenne 2 befindet einen zweiten Fokusbereich F' in der Plasma-Behandlungszone vorzusehen, der in den im folgenden beschriebenen Figuren wiederum, wie auch vorstehend, durch ein Kreuz (x) angedeutet ist.

Bei der Ausgestaltung der Fig. 14 erfolgt die Trennung von Mikrowellenerzeugungszone 23 und Plasma-Behandlungszone 24 lediglich durch eine Trennwand 26 aus einem Dielektrikum.

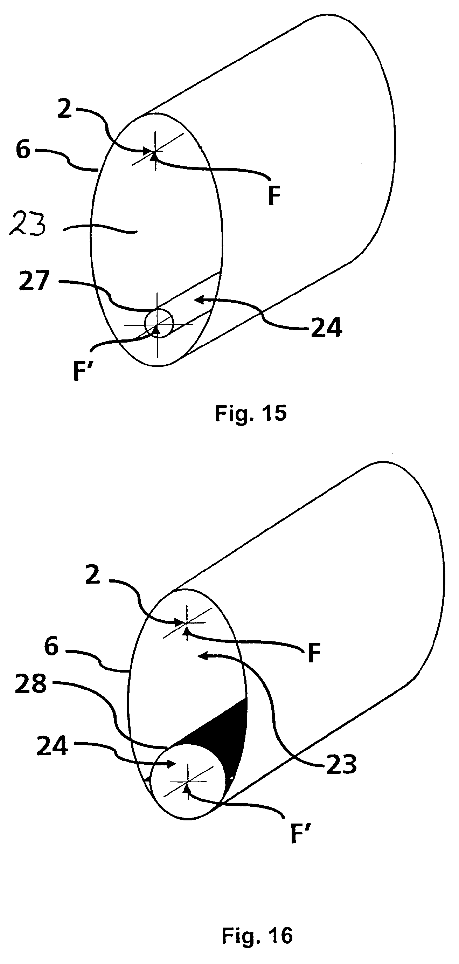

Bei der Ausgestaltung der Fig. 15 ist die Plasma-Behandlungszone durch ein im Hohlraumresonator 6 eingebrachtes Rohr 27 umschlossen.

Bei der Ausgestaltung der Fig. 16 ist die Plasma-Behandlungszone 24 um den Fokusbereich F' im ersten Scheitelbereich 8 durch einen mit dessen Wandungen gasdicht verbundenen Teilzylinder 28 vom Mikrowellenerzeugungsbereich 23 abgetrennt.

Bei der Ausgestaltung der Fig. 17 sind der die Mikrowellen-Antenne 2 umgebende erste Scheitelbereich 8 und der den Fokusbereich F' in der Plasma-Behandlungszone umgebende zweite Scheitelbereich 8'' winklig zueinander angeordnet, d.h. ihre Mittelebenen fluchten nicht, sondern sind unter einem unendlichen Winkel zueinander ausgerichtet. Die Mikrowellenstrahlung wirkt ähnlich wie bei der Ausgestaltung der Fig. 9 durch eine winklig angeordnete Reflektorfläche 20, die Strahlung von der Mikrowellen-Antenne 2 in die Plasma-Behandlungszone um den zweiten Fokusbereich F' reflektiert. Zusätzlich zur Trennwand 26 kann eine zweite Trennwand 26' vorgesehen sein.

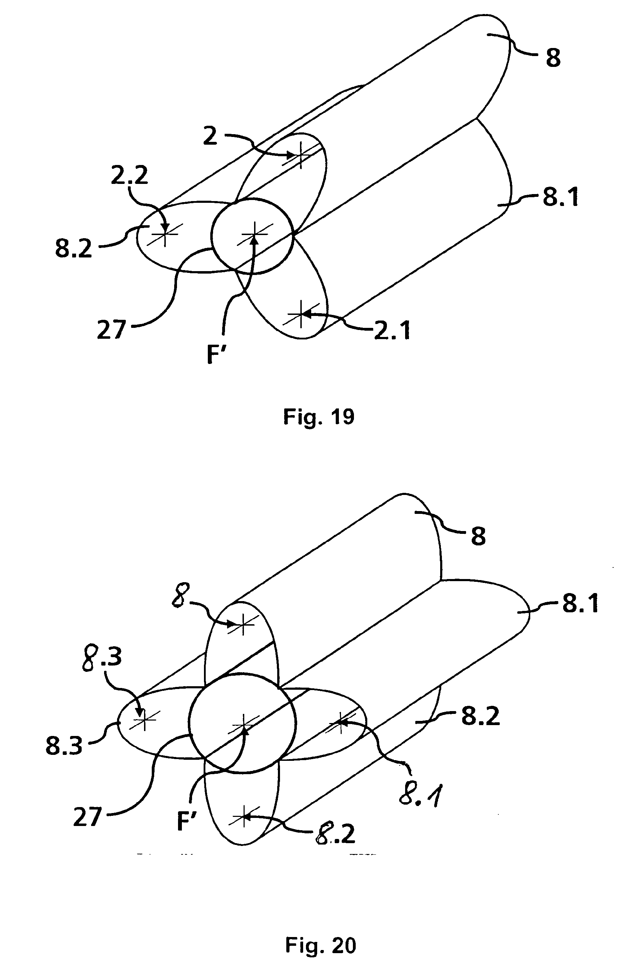

Zur Verstärkung des Mikrowelleneintrags in die Plasma-Behandlungszone 24 können wiederum mehrere Mikrowellen-Antennen 2,2.1,2.2... vorgesehen sein, wie dies in den Fig. 18 bis 20 dargestellt ist. Bei der Erzeugung von Mikrowellen zur Plasma-Behandlung sind die (mehreren) Mikrowellen-Antennen 2,2.1... dabei vorzugsweise symmetrisch um die Plasma-Behandlungszone 24 und den in dieser gegebenen, für sämtliche Mikrowellen-Antennen übereinstimmenden zweiten Fokusbereich F' der Vorrichtung angeordnet. Dies heißt bei zwei Mikrowellen-Antennen 2,2.1, daß diese sich diagonal gegenüberliegend auf einer durch die beiden Mikrowellen-Antennen und den zwischen ihnen befindlichen BehandlungsFokus F' angeordnet sind (Fig. 18); bei drei Mikrowellen-Antennen 2,2.1,2.2 sind diese unter einem Winkel von jeweils 120° um den Behandlungsfokus F' angeordnet (Fig. 19), bei vier Mikrowellen-Antennen entsprechend unter einem Winkel von 90° um den Behandlungsfokus F' (Fig. 20), etc.

Während bei der Wärmebehandlung eines Werkstücks 16, wie einer Bahn, dieses unter der Mikrowellenquelle durch den Behandlungsbereich gezogen werden kann, wobei es in diesen ein- und wieder austritt, ist dies bei einer Plasma-Behandlung eines Werkstücks, wie der Beschichtung einer Bahn in einem Plasma nicht möglich; während der Behandlung muß das gesamte Werkstück im Plasma-Behandlungsbereich verbleiben. Demgemäß sind bei der Ausgestaltung der Fig. 21 im Plasma-Behandlungsbereich 24 zwei Wickeldorne 31,32 vorgesehen, von dessen einem (beispielsweise 31) die Bahn ab- und auf dessen anderen (32) die Bahn aufgewickelt wird. Da einerseits die Wickeldorne 31,32 sich in der unmittelbaren Behandlungs-, d.h. Auftragszone bzw. im zweiten Fokus befinden sollen, die Bahn aber zur Behandlung durch diesen zu führen ist und andererseits auch die Ausgestaltung des Gehäuses bzw. der Wandung des Plasma-Behandlungsbereiches zur Erzeugung des zweiten Fokusbereiches die räumlichen Verhältnisse bestimmt, ist bei der Ausgestaltung der Fig. 19 im Fokusbereich eine Umlenkwalze 23 vorgesehen, über welche die Bahn 16 geführt wird. Es können auch in der Nähe des Fokusbereiches mehrere Führungswalzen parallel zueinander angeordnet sein.

Die Ausgestaltung der Fig. 22 betrifft die Mikrowellen-Plasma-Behandlung von Schüttgut. Damit sämtliche Teile des Schüttguts gleichmäßig und gut beschichtet werden, ist in der Plasma-Behandlungszone 24 der Ausgestaltung der Fig. 20 ein Mischer 34 angeordnet, dessen Achse vorzugsweise sich parallel zur Mikrowellen-Antenne 2 erstreckt.

Während bei der Ausgestaltung der Fig. 22 eine diskontinuierliche Behandlung des zu behandelnden Gutes gegeben ist, zeigt die Ausgestaltung der Fig. 23 eine Alternative zur kontinuierlichen Mikrowellen-Behandlung. Hierzu ist im Bereich des Behandlungsfokus F' eine Förderschnecke zur kontinuierlichen Förderung des Behandlungsgutes aus einem Vorratsbehälter in einen Aufnahmebehälter vorgesehen. Bei einer Plasma-Behandlung muß der durch die Behälter sowie den Mantel der Förderschnecke 35 umgebende Raum abgeschlossen und in geeigneter Form mit einem Behandlungsgas beaufschlagt sein. Bei lediglich einer kontinuierlichen Wärmebehandlung von Schüttgut unter Förderung mittels einer Förderschnecke 35, beispielsweise zum Trocknen von Schüttgut, ist dies nicht notwendig.

Erfindungsgemäß ist auch eine Behandlung von Abgasen möglich; diese werden durch entlang der Fokuslinie F' in einem Rohr mittels einer Förderpumpe, wie einer Wasserstrahlpumpe, gefördert.

## Patentansprüche

1. Vorrichtung zur Erzeugung von Mikrowellen zur Behandlung von Werkstücken mit mindestens einer an eine Mikrowellenquelle angeschlossenen Mikrowellen-Antenne (2) mit einem gestreckten Leiter (3) zur Erzeugung von elektromagnetischen Wechselfeldern, mit einem einen Hohlraumresonator (6) bildenden Gehäuse und mit einem Auskopplungsbereich der Mikrowellen in einem sich im wesentlichen in mindestens einem sich erweiternden ersten Scheitelbereich (8) infolge der Erweiterung ergebenden Fokusbereich des Gehäuses, wobei sich an dem mindestens sich erweiternden ersten Scheitelbereich (8) des Hohlraumresonators (6) ein zumindest nicht divergierender Gehäusebereich anschließt, **dadurch gekennzeichnet, daß** der Hohlraumresonator (6) länglich ausgebildet ist und dem Verlauf der eine über ihre Länge hin homogenen Behandlungszone erzeugenden Mikrowellen-Antenne (2) folgt, daß der gestreckte Auskopplungsbereich der Mikrowellen dem Leiter (3) folgt und daß der Auskopplungsbereich (3,13) der Mikrowelle sich im wesentlichen entlang des gestreckten Fokusbereichs des Hohlraumresonators (6) erstreckt.

2. Vorrichtung nach Anspruch 1, **dadurch gekennzeichnet, daß** die Mikrowellen-Antenne (2) ein von einem Dielektrikum umgebener elektrisch leitender gestreckter Leiter (3) ist, der sich im Fokusbereich des ersten Scheitelbereich (8,8') befindet.

3. Vorrichtung nach Anspruch 2, **dadurch gekennzeichnet, daß** das Dielektrikum ein den Leiter eng umgebender Festkörper ist.

4. Vorrichtung nach Anspruch 2, **dadurch gekennzeichnet, daß** das Dielektrikum durch ein den Leiter (3) mit Abstand umgebenes Rohr (4) und ein in diesem befindlichen Gas gebildet ist.

5. Vorrichtung nach Anspruch 1, **dadurch gekennzeichnet, daß** die Mikrowellen-Antenne (2) durch einen Koaxialleiter mit Innen- und Außenleiter gebildet ist.

6. Vorrichtung nach Anspruch 5, **dadurch gekennzeichnet, daß** der Außenleiter ein einen Innenleiter (3) lediglich teilweise umgebender Teilzylinder ist, der auf der dem Scheitel (8a) des Hohlraumresonators (6) abgewandten Bereich des Innenleiters (3) angeordnet ist.

7. Vorrichtung nach Anspruch 6, **dadurch gekennzeichnet, daß** der Außenleiter (9) eine Mantelbeschichtung auf einem den Innenleiter (3) umgebenden Dialektrikum ist.

8. Vorrichtung nach Anspruch 5, **dadurch gekennzeichnet, daß** der Außenleiter (1,12) zumindestens einen dem Scheitel (8a) des Hohlraumresonators (6) zugewandten Schlitz aufweist, der im Fokusbereich (8) des ersten Scheitelbereichs (8, 8') liegt.

9. Vorrichtung nach Anspruch 1, **dadurch gekennzeichnet, daß** die Mikrowellen-Antenne (2) durch einen Hohlleiter mit im Fokusbereich (F) des ersten Scheitelbereichs (8,8') liegenden Austrittsöffnung als Auskopplungsbereich gebildet ist.

10. Vorrichtung nach einem der vorangehenden Ansprüche, **dadurch gekennzeichnet, daß** der nicht divergierende Bereich (19,8") ein sich vom ersten Scheitelbereich (8,8') fort verjüngender zweiter Scheitelbereich (8'') ist und daß das Werkstück (16) im wesentlichen im Fokusbereich (Behandlungsfokus F') des zweiten Scheitelbereiches (8") anordbar ist.

11. Vorrichtung nach einem der vorangehenden Ansprüche, **dadurch gekennzeichnet, daß** erster Scheitelbereich (8) und nicht divergierender Bereich (19,6") unter einem endlichen Winkel zueinander angeordnet sind und daß zwischen beiden Bereichen eine Reflektionsfläche (10) vorgesehen ist.

12. Vorrichtung nach einem der vorangehenden Ansprüche, **dadurch gekennzeichnet, daß** mindestens zwei erste Scheitelbereiche (6,6') die jeweils eine Mikrowellen-Antenne (2) aufweisen, sich parallel zueinander erstreckend angeordnet sind und in einen gemeinsamen nicht divergierenden Bereich (19) übergehen.

13. Vorrichtung nach Anspruch 12, **dadurch gekennzeichnet, daß** die mindestens zwei ersten Scheitelbereiche (6,6') benachbart zueinander angeordnet sind.

14. Vorrichtung nach Anspruch 12, **dadurch gekennzeichnet, daß** zwei Mikrowellenquellen (2, 2.1) relativ zu einem zweiten Behandlungsfokus (F') diagonal gegenüber angeordnet sind.

15. Vorrichtung nach einem der Ansprüche 1 bis 11, **dadurch gekennzeichnet, daß** mehrere Mikrowellen-Antennen (2,2.1,2.2.,2.3.) zumindestens auf einer Seite eines Werkstücks (16) parallel nebeneinander in ihnen zugehörigen ersten Scheitelbereichen (8,8.1.,8.2.,8.3) angeordnet sind.

16. Vorrichtung nach einem der Ansprüche 1 bis 11, **dadurch gekennzeichnet, daß** um einen Behandlungsfokus (11) herum mehrere Mikrowellen-Antennen (2,2.1,2.2,2.3) in ihnen zugehörigen ersten Scheitelbereichen (8,8.1,8.2,8.3) symmetrisch verteilt angeordnet sind.

17. Vorrichtung nach einem der vorangehenden Ansprüche, **dadurch gekennzeichnet, daß** im Gehäuse mit Abstand zum ersten Fokusbereich (F) ein Plasma-Behandlungsbereich durch einen Trennkörper (26,27,28) vom Mikrowellenerzeugungsbereich abgegrenzt ist.

18. Vorrichtung nach Anspruch 17, **dadurch gekennzeichnet, daß** der Trennkörper im wesentlichen eine ebene Wandung (26) ist.

19. Vorrichtung nach Anspruch 17, **dadurch gekennzeichnet, daß** der Trennkörper ein halbzylindrischer Mantel ist, der über dem Behandlungsfokus (F') angeordnet und fest und dicht mit der Wandung des Gehäuses verbunden ist.

20. Vorrichtung nach Anspruch 17, **dadurch gekennzeichnet, daß** der Trennkörper durch ein den Behandlungs-fokusbereich (F') umgebendes dielektrisches Rohr (27) gebildet ist.

21. Vorrichtung nach einem der vorangehenden Ansprüche, **dadurch gekennzeichnet, daß** zur Plasmabildung eines bahnförmigen Werkstücks innerhalb des Gehäuses Ab- und Aufwickeldorne (31,32) vorgesehen und mindestens eine Umlenk- oder Führungswalze (33) in der Nähe des Behandlungsfokus (F') angeordnet ist.

22. Vorrichtung nach einem der Ansprüche 1 bis 20, **dadurch gekennzeichnet, daß** zur Mikrowellen-Behandlung von Schüttgut im Behandlungsbereich ein Mischer angeordnet ist.

23. Vorrichtung nach einem der Ansprüche 1 bis 20, **gekennzeichnet durch** eine Förderschnecke im Bereich des Behandlungsfokus (F') zur Förderung des zu behandelnden Materials.

24. Vorrichtung nach einem der Ansprüche 1 bis 20, **gekennzeichnet durch** ein sich entlang des Behandlungsfokus (F') erstreckendes, mit einer Pumpe versehenes Gasführungsrohr.

## Claims

1. Device for producing microwaves for the treatment of workpieces, having at least one microwave antenna (2) which is connected to a microwave source and has an extended guide (3) for producing electromagnetic alternating fields, having a housing which forms a cavity resonator (6) and having a decoupling region of the microwaves in a focal region of the housing which is produced essentially in at least one widening first apex region (8) as a result of the widening, an at least non-diverging housing region being connected to the at least widening first apex region (8) of the cavity resonator (6), **characterised in that** the cavity resonator (6) has an oblong configuration and follows the course of the microwave antenna (2) which produces a homogeneous treatment zone over the length thereof, **in that** the extended decoupling region of the microwaves follows the guide (3) and **in that** the decoupling region (3, 13) of the microwaves extends essentially along the extended focal region of the cavity resonator (6).

2. Device according to claim 1, **characterised in that** the microwave antenna (2) is an electrically conducting extended guide (3) which is surrounded by a dielectric and is situated in the focal region of the first apex region (8, 8').

3. Device according to claim 2, **characterised in that** the dielectric is a solid body which closely surrounds the guide.

4. Device according to claim 2, **characterised in that** the dielectric is formed by a pipe (4) which surrounds the guide (3) at a spacing and by a gas situated in the latter.

5. Device according to claim 1, **characterised in that** the microwave antenna (2) is formed by a coaxial guide with an inner and outer guide.

6. Device according to claim 5, **characterised in that** the outer guide is a partial cylinder which only partially surrounds an inner guide (3) and is disposed on the region of the inner guide (3) which is orientated away from the apex (8a) of the cavity resonator (6).

7. Device according to claim 6, **characterised in that** the outer guide (9) is an outer peripheral coating on a dielectric which surrounds the inner guide (3).

8. Device according to claim 5, **characterised in that** the outer guide (1, 12) has at least one slot which is orientated towards the apex (8a) of the cavity resonator (6) and is situated in the focal region (8) of the first apex region (8, 8').

9. Device according to claim 1, **characterised in that** the microwave antenna (2) is formed by a wave guide having an outlet opening as decoupling region which is situated in the focal region (F) of the first apex region (8, 8').

10. Device according to one of the preceding claims, **characterised in that** the non-diverging region (19, 8") is a second apex region (8") which tapers away from the first apex region (8, 8') and **in that** the workpiece (16) can be disposed essentially in the focal region (treatment focal point F') of the second apex region (8").

11. Device according to one of the preceding claims, **characterised in that** the first apex region (8) and non-diverging region (19, 6") are disposed at a finite angle relative to each other and **in that** a reflection surface (10) is provided between both regions.

12. Device according to one of the preceding claims, **characterised in that** at least two first apex regions (6, 6'), which respectively have a microwave antenna (2), are disposed extending parallel to each other and merge into a common non-diverging region (19).

13. Device according to claim 12, **characterised in that** the at least two first apex regions (6, 6') are disposed adjacent to each other.

14. Device according to claim 12, **characterised in that** two microwave sources (2, 2.1) are disposed diagonally opposite relative to a second treatment focal point (F').

15. Device according to one of the claims 1 to 11, **characterised in that** a plurality of microwave antennae (2, 2.1, 2.2, 2.3) in first apex regions (8, 8.1, 8.2, 8.3) associated therewith is disposed at least on one side of a workpiece (16) parallel and adjacent to each other.

16. Device according to one of the claims 1 to 11, **characterised in that** a plurality of microwave antennae (2, 2.1, 2.2, 2.3) in first apex regions (8, 8.1, 8.2, 8.3) associated therewith is disposed symmetrically distributed about a treatment focal point (11).

17. Device according to one of the preceding claims, **characterised in that** a plasma treatment region is delimited from the microwave production region by a separating body (26, 27, 28) in the housing at a spacing from the first focal region (F).

18. Device according to claim 17, **characterised in that** the separating body is essentially a flat wall (26).

19. Device according to claim 17, **characterised in that** the separating body is a semi-cylindrical sleeve which is disposed above the treatment focal point (F') and is connected securely and tightly to the wall of the housing.

20. Device according to claim 17, **characterised in that** the separating body is formed by a dielectric pipe (27) which surrounds the treatment focal region (F').

21. Device according to one of the preceding claims, **characterised in that** take-off and take-up mandrels (31, 32) are provided within the housing for the plasma formation of a web-like workpiece and at least one deflection or guide roller (33) is disposed in the vicinity of the treatment focal point (F').

22. Device according to one of the claims 1 to 20, **characterised in that** a mixer is disposed in the treatment region for microwave treatment of bulk material.

23. Device according to one of the claims 1 to 20, **characterised by** a conveying screw in the region of the treatment focal point (F') for conveying the material to be treated.

24. Device according to one of the claims 1 to 20, **characterised by** a gas conveying pipe which extends along the treatment focal point (F') and is provided with a pump.

## Revendications

1. Dispositif pour produire des micro-ondes pour traiter des pièces avec au moins une antenne à micro-ondes (2) connectée à une source de micro-ondes, un guide étendu (3) pour produire des champs électromagnétiques alternatifs, une enveloppe formant un résonateur à cavité (6) et une zone de découplage des micro-ondes dans au moins une première zone sommitale (8) s'élargissant du fait de l'élargissement de la zone de focalisation de l'enveloppe, au moins une zone d'enveloppe non divergente se raccordant à la première zone sommitale (8) s'élargissant du résonateur à cavité (6),
**caractérisé en ce que**
le résonateur à cavité (6) est de forme oblongue et suit la forme de l'antenne à micro-ondes (2) produisant une zone de traitement homogène sur toute sa longueur, la zone de découplage étendue des micro-ondes suit le guide (3) et la zone de découplage (3, 13) des micro-ondes s'étend sensiblement le long de la zone de focalisation étendue du résonateur à cavité (6).

2. Dispositif selon la revendication 1,
**caractérisé en ce que**
l'antenne à micro-ondes (2) est constituée par un guide électroconducteur (3) entouré d'un corps diélectrique qui se trouve dans la zone de focalisation de la première zone sommitale (8, 8').

3. Dispositif selon la revendication 2,
**caractérisé en ce que**
le corps diélectrique est un semi-conducteur entourant de près le guide.

4. Dispositif selon la revendication 2,
**caractérisé en ce que**
le corps diélectrique est constitué par un tube (4) entourant le guide (3) à distance et un gaz se trouvant à l'intérieur.

5. Dispositif selon la revendication 1,
**caractérisé en ce que**
l'antenne à micro-ondes (2) est constituée par un guide coaxial avec des guides intérieur et extérieur.

6. Dispositif selon la revendication 5,
**caractérisé en ce que**
le guide extérieur est simplement un segment cylindrique entourant partiellement le guide intérieur (3), qui est placé sur la zone du guide intérieur (3) opposée à la zone sommitale (8a) du résonateur à cavité (6).

7. Dispositif selon la revendication 6,
**caractérisé en ce que**
le guide extérieur (9) est un revêtement déposé sur un corps diélectrique entourant le guide intérieur (3).

8. Dispositif selon la revendication 5,
**caractérisé en ce que**
le guide extérieur (1, 12) possède au moins une fente orientée vers le sommet (8a) du résonateur à cavité (6), qui se trouve dans la zone de focalisation (8) de la première zone sommitale (8, 8').

9. Dispositif selon la revendication 1,
**caractérisé en ce que**
l'antenne à micro-ondes (2) est formée par un guide creux avec une ouverture de sortie dans la zone de focalisation (F) de la première zone sommitale (8, 8') en guise de zone de découplage.

10. Dispositif selon une des revendications précédentes,
**caractérisé en ce que**
la zone non divergente (19, 8") est une deuxième zone sommitale (8") s'effilant à partir de la première zone sommitale (8, 8'), et la pièce à traiter (16) peut être placée sensiblement dans la zone de focalisation (foyer de traitement F') de la deuxième zone sommitale (8").

11. Dispositif selon une des revendications précédentes,
**caractérisé en ce que**
la première zone sommitale (8) et la zone non divergente (19, 6") forment un angle final entre elles, et une surface réfléchissante (10) est prévue entre les deux zones.

12. Dispositif selon une des revendications précédentes,
**caractérisé en ce qu'**
au moins deux premières zones sommitales (6, 6') qui possèdent chacune une antenne à micro-ondes (2) sont parallèles et se poursuivent dans une zone non divergente commune (19).

13. Dispositif selon la revendication 12,
**caractérisé en ce qu'**
au moins deux premières zones sommitales (6, 6') sont voisines.

14. Dispositif selon la revendication 12,
**caractérisé en ce que**
deux sources de micro-ondes (2, 2.1) sont diamétralement opposées par rapport à un deuxième foyer de traitement (F').

15. Dispositif selon une des revendications 1 à 11,
**caractérisé en ce qu'**
au moins d'un côté d'une pièce à traiter (16), plusieurs antennes à micro-ondes (2, 2.1, 2.2, 2.3) sont parallèles les unes à côté des autres dans des premières zones sommitales (8, 8.1, 8.2, 8.3) qui leur sont associées.

16. Dispositif selon une des revendications 1 à 11,
**caractérisé en ce que**
plusieurs antennes à micro-ondes (2, 2.1, 2.2, 2.3) sont réparties symétriquement autour d'un foyer de traitement (11) dans des premières zones sommitales (8, 8.1, 8.2, 8.3) qui leur sont associées.

17. Dispositif selon une des revendications précédentes,
**caractérisé en ce que**
dans l'enveloppe, à distance de la première zone de focalisation (F), une zone de traitement plasma est séparée de la zone de production de micro-ondes par un élément de séparation (26, 27, 28).

18. Dispositif selon la revendication 17,
**caractérisé en ce que**
l'élément de séparation est essentiellement une paroi plane (26).

19. Dispositif selon la revendication 17,
**caractérisé en ce que**
l'élément de séparation est une enveloppe semi-cylindrique montée sur le foyer de traitement (F') et fïxée de manière étanche sur la paroi de l'enveloppe.

20. Dispositif selon la revendication 17,
**caractérisé en ce que**
l'élément de séparation est formé par un tube diélectrique (27) entourant le foyer de traitement (F').

21. Dispositif selon une des revendications précédentes,
**caractérisé en ce que**
pour la formation de plasma d'une pièce à traiter en forme de bande à l'intérieur de l'enveloppe, des axes de déroulement et d'enroulement (31, 32) et au moins un cylindre de déviation ou de guidage (33) sont disposés à proximité du foyer de traitement (F4).

22. Dispositif selon une des revendications 1 à 20,
**caractérisé en ce que**
pour traiter aux micro-ondes un matériau en vrac, un mélangeur est disposé dans la zone de traitement.

23. Dispositif selon une des revendications 1 à 20,
**caractérisé par**
une vis de transport dans la zone du foyer de traitement (F') pour transporter le matériau à traiter.

24. Dispositif selon une des revendications 1 à 20,
**caractérisé par**
une conduite de gaz dotée d'une pompe, s'étendant le long du foyer de traitement (F').
